# EUROPEAN PATENT APPLICATION

(11) **EP 1 734 656 A1**
(43) Date of publication of application: **20.12.2006**
(21) Application number: 06252278.4
(22) Date of filing: 27.04.2006
(51) Int. Cl.: H03K 5/15, H03K 5/156

(54) **Cascade system capable of restraining duty cycle offsets**

(30) Priority: 16.06.2005 CN 200510077207
(71) Applicant: Himax Technologies, Inc., Taiwan (CN)
(72) Inventor: Wu, Tsung-Yu, Himax Technologies, Inc., Tainan County Taiwan (CN); Bu, Lin-Kai, Himax Technologies, Inc., Tainan County Taiwan (CN)
(74) Representative: Nicholls, Michael John

(57) **Abstract**

The invention relates to a cascade system capable of restraining duty cycle offsets. The cascade system receives an input signal with an input duty cycle. The cascade system comprises a plurality of circuit units. The circuit units are connected in series. Each circuit unit receives a signal from a previous circuit unit. Through at least one circuit unit, a duty cycle offset exists between the processing duty cycle and the input duty cycle. At least one circuit unit is selected at predetermined intervals, and the processing signal thereof is inverted so that the duty cycle offsets are compensated for and restrained within a predetermined range

## Description

The invention relates to a cascade system, and more particularly, relates to a cascade system capable of restraining duty cycle offsets.

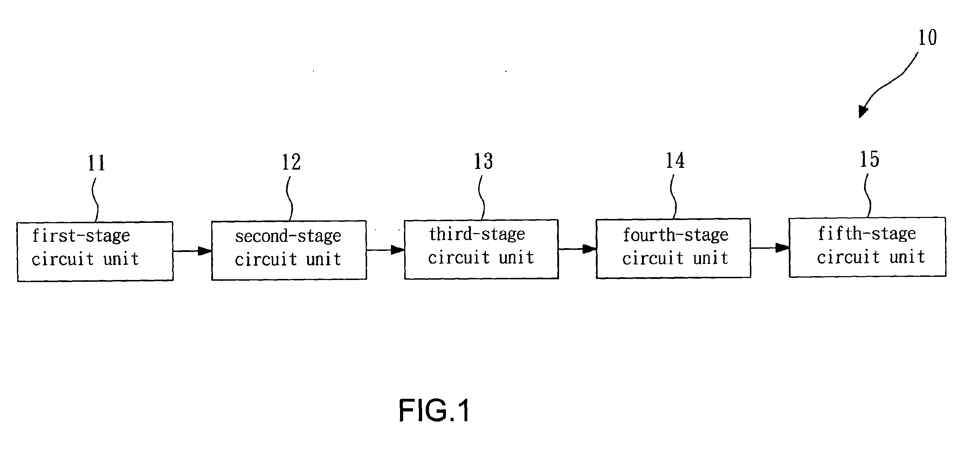

With reference to FIG. 1, a conventional cascade system 10 comprises a plurality of circuit units 11, 12, 13, 14, 15, etc. The circuit units are connected in series. Each circuit unit receives a signal from a previous circuit unit. For example, a first-stage circuit unit 11 receives an input signal, a second-stage circuit unit 12 receives a signal from the first-stage circuit unit 11, and then a third-stage circuit unit 13 receives a signal from the second-stage circuit unit 12.

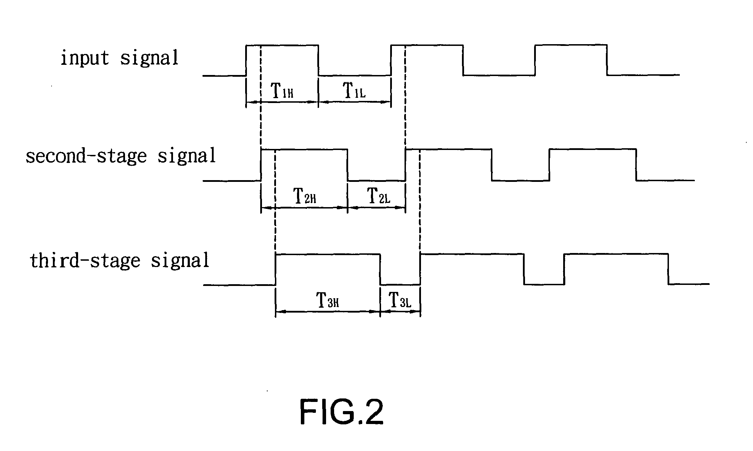

When the cascade system 10 is disposed on a panel and transmits a signal on it, the duty cycle of the transmitted signal will change because of the parasitic resistance (R) and parasitic capacitance (C) on the panel. With reference to FIG. 2, it shows the duty cycle timing of the signal transmitted by the conventional cascade system 10, wherein the input signal has an input duty cycle with an input high potential duration T_{1H} and an input low potential duration T_{1L}. The ratio of the input high potential duration T_{1H} and the input low potential duration T_{1L} is 50:50, that is, the duty cycle of the input signal is 50%.

The input signal is transmitted to the second-stage circuit unit 12 through the first-stage circuit unit 11. The second-stage circuit unit 12 receives a second-stage signal with a second-stage duty cycle. The second-stage duty cycle has a second-stage high potential duration T_{2H} and a second-stage low potential duration T_{2L}. The ratio of the second-stage high potential duration T_{2H} and the second-stage low potential duration T_{2L} is 60:40, that is, the duty cycle of the second-stage signal changes to 60%. The reason for this is that there is parasitic resistance and parasitic capacitance on the panel, such that the duty cycle of the second-stage signal received by the second-stage circuit unit 12 is larger than 50%, and the second-stage signal is delayed for a period compared with the input signal.

The second-stage signal is transmitted to the third-stage circuit unit 13 through the second-stage circuit unit 12, and the third-stage circuit unit 13 receives a third-stage signal. Similarly, the third-stage signal has a third-stage duty cycle with a third-stage high potential duration T_{3H} and a third-stage low potential duration T_{3L}. The ratio of the third-stage high potential duration T_{3H} and the third-stage low potential duration T_{3L} is 72:28, that is, the duty cycle of the third-stage signal changes to 72%, which is also caused by the parasitic resistance and parasitic capacity on the panel. As the duty cycle changes significantly, it may cause a system malfunction.

If the third-stage signal is then transmitted to the fourth-stage circuit unit 14, the duty cycle of the fourth-stage signal received by the fourth-stage circuit unit 14 may be 90%. If the fourth-stage signal is then transmitted to the fifth-stage circuit unit 15, the duty cycle of the fifth-stage signal received by the fifth-stage circuit unit 15 may be 100%, thus becoming direct current and resulting in a system malfunction.

Therefore, it is necessary to provide a cascade system to solve the above problems.

The objective of the invention is to provide a cascade system capable of restraining duty cycle offsets. The cascade system receives an input signal with an input duty cycle. The cascade system comprises a plurality of circuit units. The circuit units are connected in series. Each circuit unit receives a signal from a previous circuit unit. Through at least one circuit unit, a duty cycle offset exists between the processing duty cycle and the input duty cycle. At least one circuit unit is selected at predetermined intervals, and the processing signal thereof is inverted so that the duty cycle offsets are compensated for and restrained within a predetermined range.

According to the cascade system of the invention, when a signal is transmitted through each circuit unit and its duty cycle changes, and generates a duty cycle offset, the processing signal is inverted in the selected circuit unit. The inverted signal may be transmitted to compensate for and restrain the duty cycle offset of each circuit unit of the cascade system.

The invention will be further described by way of example with reference to the accompanying drawings, in which:-
FIG. 1 is a schematic view of a conventional cascade system;
FIG. 2 shows duty cycle timing of the signal transmitted by the conventional cascade system;
FIG. 3 is a schematic view of a cascade system of the invention; and
FIG. 4 shows duty cycle timing of the signal transmitted by the cascade system of the invention.

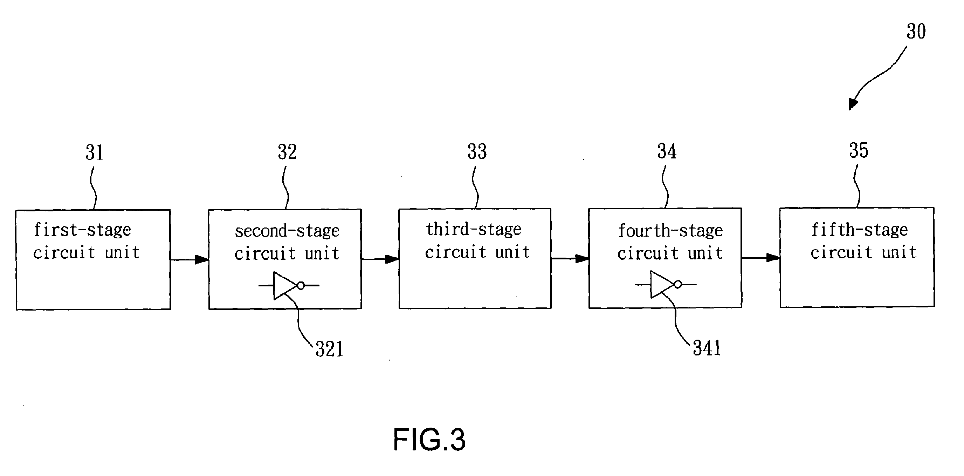

Referring to FIG. 3, it shows the cascade system 30 capable of restraining duty cycle offsets according to the invention. The cascade system 30 comprises a plurality of circuit units 31, 32, 33, 34, 35, etc. The circuit units are connected in series. Each circuit unit receives signal from a previous circuit unit. For example, a first-stage circuit unit 31 receives an input signal, a second-stage circuit unit 32 receives a signal from the first-stage circuit unit 31, and then a third-stage circuit unit 33 receives a signal from the second-stage circuit unit 32.

As described in the prior art, when the cascade system is disposed on a panel and transmits a signal on it, the duty cycle of the transmitted signal will change because of the parasitic resistance and parasitic capacitance on the panel. Thus, when the signal is transmitted through each circuit unit and its duty cycle changes, and generates a duty cycle offset, the processing signal is inverted in the selected circuit unit (for example, the second-stage circuit unit 32 and the fourth-stage circuit unit 34) by the cascade system 30 of the invention. The inverted signal may be transmitted to compensate for the duty cycle offset, so as to restrain the duty cycle offset within a predetermined range.

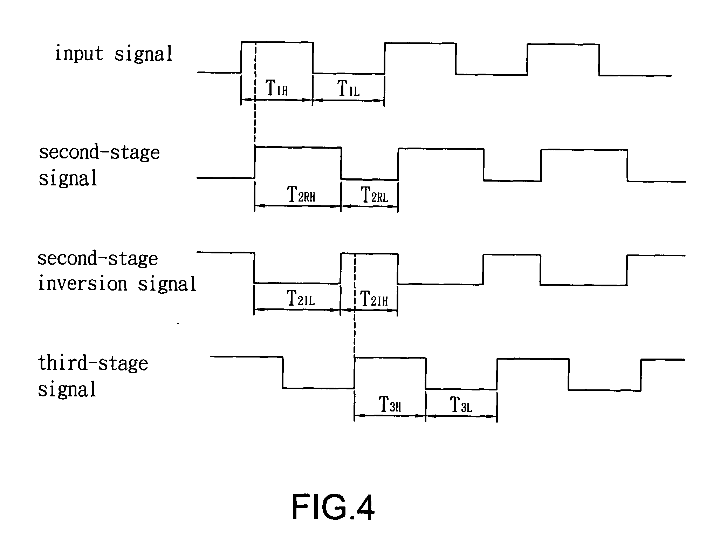

With reference to FIG. 4, it shows duty cycle timing of the signal transmitted by the cascade system 30 of the invention, wherein the input signal has an input duty cycle with an input high potential duration T_{1H} and an input low potential duration T_{1L}. The ratio of the input high potential duration T_{1H} and the input low potential duration T_{1L} is 50:50, that is, the duty cycle of the input signal is 50%.

The input signal is transmitted to the second-stage circuit unit 32 through the first-stage circuit unit 31. The second-stage circuit unit 32 receives a second-stage signal with a second-stage duty cycle. The second-stage duty cycle has a second-stage receiving high potential duration T_{2RH} and a second-stage receiving low potential duration T_{2RL}. The ratio of the second-stage receiving high potential duration T_{2RH} and the second-stage receiving low potential duration T_{2RL} is 60:40, that is, the duty cycle of the second-stage signal changes to 60%. And the second-stage receiving high potential duration T_{2RH} is larger than the input high potential duration T_{1H}. The reason for this is as described above, there is parasitic resistance and parasitic capacitance on the panel, such that the duty cycle of the second-stage signal received by the second-stage circuit unit 32 is larger than 50%, and the second-stage signal is delayed for a period compared with the input signal.

Since the second-stage signal received by the second-stage circuit unit 32 has generated a first duty cycle offset (about 10%), the second-stage signal may be inverted to a second-stage inversion signal in the second-stage circuit unit 32 by an inverter 321. The second-stage inversion signal has a second-stage inversion duty cycle with a second-stage inversion high potential duration T_{2IH} and a second-stage inversion low potential duration T_{2IL}. The ratio of the second-stage inversion high potential duration T_{2IH} and the second-stage inversion low potential duration T_{2IL} is 40:60. The second-stage inversion high potential duration T_{2IH} is equal to the second-stage receiving low potential duration T_{2RL}, and the second-stage inversion low potential duration T_{2IL} is equal to the second-stage receiving high potential duration T_{2RH}.

Adding an inverter 321 to the second-stage circuit unit 32, or the existing inversion function of the second-stage circuit unit can achieve the process of inverting the second-stage signal to the second-stage inversion signal. For example, the second-stage circuit unit may be an RSDS (Reduced Swing Differential Signal) data driver, in which there is already a POLINV function by which the second-stage signal may be inverted to the second-stage inversion signal.

Furthermore, when the second-stage signal is inverted to the second-stage inversion signal in the second-stage circuit unit 32, the second-stage signal may be inverted to the second-stage inversion signal at the receiving terminal, the transmission terminal of the second-stage circuit unit 32 or during signal processing. That is, the second-stage signal is inverted to the second-stage inversion signal once the second-stage circuit unit 32 receives it; or the second-stage signal is inverted to the second-stage inversion signal following some signal processing steps after it is received by the second-stage circuit unit 32; alternatively, the second-stage signal is inverted to the second-stage inversion signal after it is received and processed by the second-stage circuit unit 32 and before it is outputted to the third-stage circuit unit 33. In the embodiment, take the following as an example: the second-stage signal is inverted to the second-stage inversion signal once the second-stage circuit unit 32 receives it.

Since the duty cycle offset of about 10% is caused after a signal is processed and transmitted by the first-stage circuit unit 31, it is predicted that the duty cycle offset of about 10% may also be caused after the signal is processed and transmitted by the second-stage circuit unit 32. However, the processed and transmitted signal is the second-stage inversion signal in the second-stage circuit unit 32, and the ratio of the second-stage inversion high potential duration T_{2IH} and the second-stage inversion low potential duration T_{2IL} is 40:60. That is, the duty cycle offset of the second-stage inversion signal is a negative first duty cycle offset (about -10%). Thus, it is processed and transmitted by the second-stage circuit unit 32, and transmitted to the third-stage circuit unit 33. The third-stage circuit unit 33 receives a third-stage signal with a third-stage duty cycle. The third-stage duty cycle has a third-stage receiving high potential duration T_{3H} and a third-stage receiving low potential duration T_{3L}. The ratio of the third-stage receiving high potential duration T_{3H} and the third-stage receiving low potential duration T_{3L} is 50:50, that is, the duty cycle of the third-stage signal is 50%.

That is, there is a second-stage duty cycle offset (also about 10%) between the third-stage duty cycle and the second-stage inversion duty cycle. The second-stage duty cycle offset may compensate for the negative first duty cycle offset (about -10%) of the second-stage inversion duty cycle. Therefore, the second-stage signal is inverted to the second-stage inversion signal so as to keep the duty cycle of the third-stage signal received by the third-stage circuit unit 33 the same as the input duty cycle (50%).

Similarly, if the duty cycle offset of about 10% is caused after the signal is processed and transmitted by the third-stage circuit unit 33, the received fourth-stage signal may be inverted to the fourth-stage inversion signal by an inverter 341 in the fourth-stage circuit unit 34 or the existing inversion function of the circuit unit. And then it is processed and transmitted by the fourth-stage circuit unit 34 to reversely compensate for the duty cycle offset of 10%, so that the duty cycle of the fifth-stage signal received by the fifth-stage circuit unit 35 may be kept the same as the input duty cycle (50%).

Therefore, according to a predetermined interval (the interval in the embodiment of the invention is 2), at least one circuit unit is selected by the cascade system 30 of the invention and the processing signal is inverted in the circuit unit. The inversion signal is transmitted to compensate for the duty cycle offset generated by the transmission of the signal through each circuit unit so as to keep the duty cycle fixed between 50% and 60% or between 40% and 50%. Therefore, the offset between the processing duty cycle of each circuit unit and the input duty cycle is kept within a predetermined range (0-10% in the embodiment of the invention), so that the error due to the overly large duty cycle offset of the signal may not occur in the entire cascade system, and the cascade system can operate normally on the panel.

In addition, the interval described above may be fixed or non-fixed. If it is fixed, the processing signal can be inverted in the even circuit units such as the second-stage circuit unit, and the fourth-stage circuit unit, etc., as described in the embodiment of the invention. If it is non-fixed, the processing signal may be inverted in the selected circuit units of a nonspecific interval such as the second-stage circuit unit, and the fifth-stage circuit unit, etc. The interval may be determined according to the characteristics of the circuit unit.

While several embodiments of the present invention have been illustrated and described, various modifications and improvements can be made by those skilled in the art. The embodiment of the present invention is therefore described in an illustrative, but not restrictive, sense. It is intended that the present invention may not be limited to the particular forms as illustrated, and that all modifications which maintain the spirit and scope of the present invention are within the scope as defined in the appended claims.

## Claims

1. A cascade system capable of restraining duty cycle offsets, receiving an input signal with an input duty cycle, the cascade system comprising:
a plurality of circuit units connected in series, each of which receives a signal from a previous circuit unit and has a processing signal with a processing duty cycle, and through at least one of which a duty cycle offset exists between the processing duty cycle and the input duty cycle;
wherein at least one circuit unit is selected at predetermined intervals, and the processing signal thereof is inverted so that the duty cycle offsets are compensated and restrained within a predetermined range.

2. The cascade system according to Claim 1, wherein the circuit units comprise:
a first-stage circuit unit, for receiving the input signal, the input signal processed by the first-stage circuit unit;
a second-stage circuit unit, for receiving a second-stage signal from the first-stage circuit unit, wherein the second-stage signal has a second-stage duty cycle; there is a first duty cycle offset between the second-stage duty cycle and the input duty cycle; the second-stage signal is inverted to a second-stage inversion signal with a second-stage inversion duty cycle; and there is a negative first duty cycle offset between the second-stage inversion duty cycle and the input duty cycle; and
a third-stage circuit unit, for receiving a third-stage signal from the second-stage circuit unit, wherein the third-stage signal has a third-stage duty cycle; there is a second duty cycle offset between the third-stage duty cycle and the second-stage inversion duty cycle; and the second duty cycle offset compensates the negative first duty cycle offset.

3. The cascade system according to Claim 2, wherein the input duty cycle has an input high potential duration and an input low potential duration; the second-stage duty cycle has a second-stage receiving high potential duration and a second-stage receiving low potential duration, and the second-stage receiving high potential duration is larger than the input high potential duration, generating the first duty cycle offset; the second-stage inversion duty cycle has a second-stage inversion high potential duration and a second-stage inversion low potential duration, the second-stage inversion high potential duration is equal to the second-stage receiving low potential duration, the second-stage inversion low potential duration is equal to the second-stage receiving high potential duration, and the second-stage inversion high potential duration is less than the input high potential duration, generating the negative first duty cycle offset; the third-stage duty cycle has a third-stage receiving high potential duration and a third-stage receiving low potential duration, and the third-stage receiving high potential duration is larger than the second-stage inversion high potential duration, generating the second duty cycle offset.

4. The cascade system according to Claim 1, 2 or 3 wherein the predetermined intervals are two circuit units.

5. The cascade system according to Claim 1, 2, 3 or 4 wherein the predetermined range of the duty cycle offset is 0-10%.

6. The cascade system according to Claim 1, 2, 3, 4 or 5 wherein the processing signal of the circuit unit is a signal received from a previous circuit unit.

7. The cascade system according to any one of the preceding claims, wherein the selected circuit unit comprises an inverter for inverting the processing signal.

8. The cascade system according to any one of claims 1 to 6, wherein the processing signal is inverted at a receiving terminal of the selected circuit unit.

9. The cascade system according to any one of claims 1 to 6, wherein the processing signal is inverted at a transmission terminal of the selected circuit unit.

10. The cascade system according to any one of claims 1 to 6, wherein the processing signal is inverted during the signal processing of the selected circuit unit.
